# EUROPÄISCHE PATENTSCHRIFT

(11) **EP 2 908 602 B1**
(45) Veröffentlichungstag und Bekanntmachung des Hinweises auf die Patenterteilung: **03.02.2016**
(21) Anmeldenummer: 15000317.6
(22) Anmeldetag: 04.02.2015
(51) Int. Cl.: H05B 6/06, H05B 6/10, G01R 19/00, H05B 6/02

(54) **Verfahren zum Überwachen einer Einrichtung zum induktiven Erwärmen**
Method for monitoring a device for inductive heating
Procédé de surveillance d'un dispositif destiné au chauffage inductif

(30) Priorität: 12.02.2014 DE 102014001935
(43) Veröffentlichungstag der Anmeldung: 19.08.2015
(73) Patentinhaber: EMAG Holding GmbH, 73084 Salach (DE)
(72) Erfinder: Krötz, Harry, D-72250 Freudenstadt (DE)

(56) Entgegenhaltungen:
- DE-A1- 10 115 326
- US-A- 3 746 825
- US-A- 5 630 957

## Beschreibung

Die Erfindung betrifft ein Verfahren zum Überwachen einer Einrichtung zum Erwärmen von Bauteilen mittels einer Induktionsspule nach dem Oberbegriff des Patentanspruchs 1. Solche Einrichtungen werden beispielsweise zum Härten von Werkstücken eingesetzt. Aus der DE 2 322 720 A ist eine Schaltungsanordnung zur Überwachung einer Induktionshärteanlage bekannt. Dabei wird die der Härteanlage zugeführte Wärmemenge als elektrische Energie ermittelt, Indem der Induktionsspannung und dem Induktionsstrom proportionale Spannungen einem Multiplizierer aufgeschaltet werden. Well die zugeführte Leistung sich während der Heizphase verändert, wird sie über die Aufheizzeit integriert. Zu diesem Zweck ist der Ausgang des Multiplizierers mit dem Eingang eines Integrators verbunden. Mit dem Ausgabewert der Schaltungsanordnung können unter anderem Rückschlüsse auf Härtetemperatur, Erwärmungstiefe oder auf den Wirkungsgrad des Induktors geschlossen werden. Ein Nachteil besteht bei geregelten Härteeinrichtungen darin, dass bestimmte Fehler, beispielsweise im Schwingkreis des Wechselstromgenerators, nicht detektiert werden können, weil sie von der Regelung kompensiert werden. Es ist die Aufgabe der vorliegenden Erfindung ein Verfahren zum Überwachen einer Einrichtung zum Induktiven Erwärmen aufzuzelgen, welche die Nachteile Im Stand der Technik nicht aufweist.

Diese Aufgabe wird gelöst mit einem Verfahren nach Patentanspruch 1. Vorteilhafte Weiterbildungen sind Gegenstand der Unteransprüche.

Ein vorteilhafter Aspekt der Erfindung besteht darin in Einrichtungen zum induktiven Erwärmen die an der Induktionsspule abfallende Scheinspannung zu messen, diese Ober die Aufheizzeit zu integrieren und eine entsprechende Spannungszeltfläche zu erstellen. Der magnetische Fluss einer Leiterschlelfe hängt nur von der angelegten Spannungszeltfläche ab und über ihn findet die Kopplung an das zu erwärmende Bauteil statt. Abhängig vom Erwärmungszustand des Bauteils stellt das System Induktionsspule - Bauteil einen mehr oder weniger belasteten Transformator dar. Ein Vergleich mit vorher ermittelten Referenzwerten der Spannungszeitfläche ermöglicht unter anderem Rückschlüsse auf die Induktionsspulengeometrle, die magnetische Kopplung zwischen Induktionsspule und dem zu erwärmenden Bauteil oder auf die Frequenz und Amplitude des Induktionsspulenstroms. Mit diesem Verfahren werden außerdem auch Fehler auf der Generatorseite erfasst. Im Folgenden wird die Erfindung an Hand eines Ausführungsbeispiels beschrieben.

Es zeigen:
Fig. 1 den Lastzweig einer Einrichtung zum Induktiven Erwärmen von Werkstücken Fig. 2a eine Spannungszeltfläche bei sinusförmigem Spannungsverlauf
Fig. 2b eine Spannungszeitfläche über den Mittelwert des Betrags der Wechselspannung Fig. 3a bis 3c eine MF-Spannung mit überlagerter HF-Spannung mit zugehörigen Spannungszeitflächen

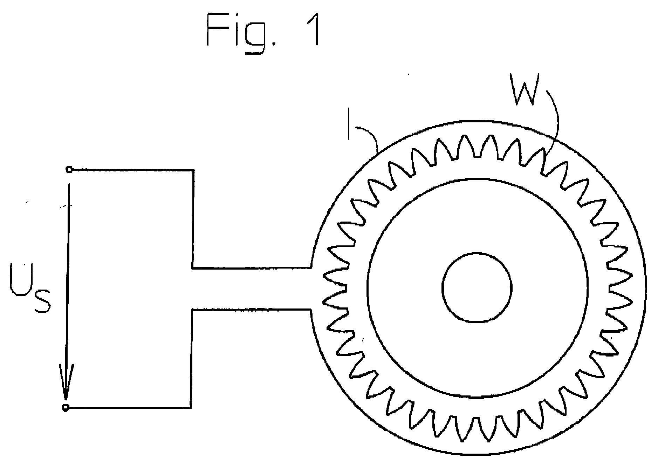

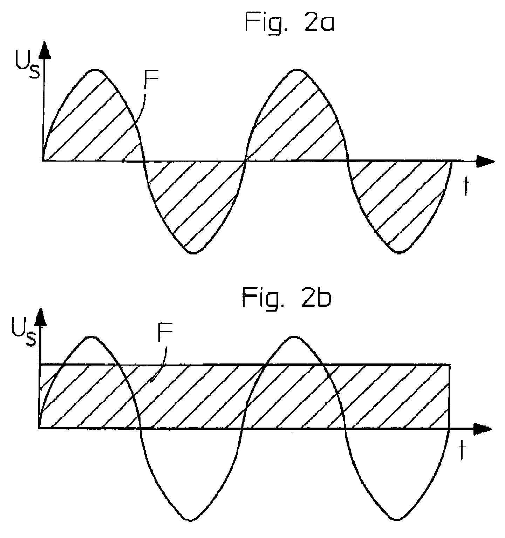

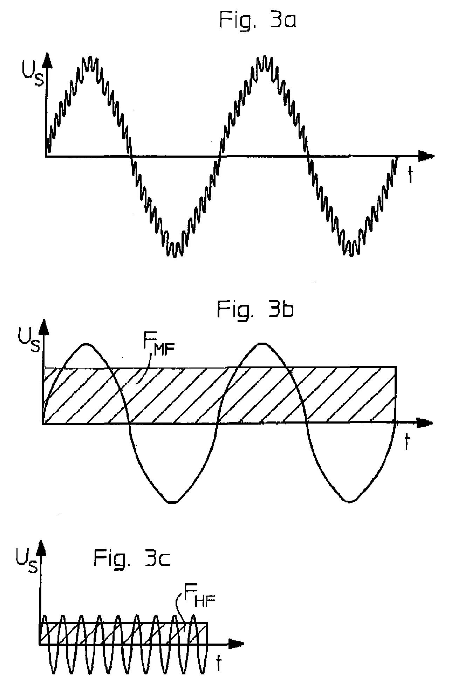

Die Erfindung wird am Beispiel einer Härteelnrichtung für Werkstücke, die mit einer Induktionsspule erwärmt werden, näher erläutert. In Fig. 1 ist der Lastzweig dieser Einrichtung dargestellt. Das Werkstück W wird von der Induktionsspule I induktiv erwärmt. Die Induktionsspule I ist an einen nicht dargestellten Generator angeschlossen. Die Induktionsspule I weist einen vom Werkstück W beeinflussten Prozesswiderstand auf. Während der induktiven Erwärmung fällt an diesem Prozesswidefstand die Spannung Uₛ ab. Diese verändert sich, wenn sich beispielsweise der Werkstoff oder die Temperatur des Werkstücks W, die Geometrie der Induktionsspule I, die magnetische Kopplung zwischen Induktionsspule I und Werkstück W oder Frequenz oder Amplitude des Stroms ändern. Gleichzeitig wird auch ein Fehlverhalten des Generators beispielsweise im Schwingkreis oder Wechselrichter erfasst. In Fig. 2a ist die Spannungszeitfläche F für eine sinusförmig verlaufende Wechselspannung dargestellt. Der Vergleich der Spannungszeitfläche F mit vorher ermittelten Referenzwerten gibt Aufschluss darüber, ob der Erwärmungsvorgang erfolgreich abgeschlossen Ist. Zur Ermittlung des Spannungsverlaufs kann die Wechselspannung abgetastet werden. Insbesondere bei hohen Frequenzen von z.B. 300 kHz ist dieser Vorgang aufwändig, weil die Abtastrate mindestens doppelt so hoch sein muss wie der höchste Frequenzanteil des Wechselspannungssignals. Eine vorteilhafte Ausführung ist aus Fig. 2b ersichtlich. Dort wurde aus der gleichgerichteten Wechselspannung ein Mittelwert gebildet und zur Ermittlung der Spannungszeitfläche F herangezogen. Dabei kann ein beliebiger mathematischer Mittelwert, z.B. der geometrische, der arithmetische oder auch der quadratische verwendet werden. Die Figur 3a zeigt eine mittelfrequente Spannung, der eine hochfrequente Spannung überlagert ist. Zur Bildung von Spannungszeitflächen wird die Spannung besonders vorteilhaft in einen mittelfrequenten und einen hochfrequenten Teil aufgespaltet. Gemäß Fig. 3b wird für den mittelfrequenten Teil eine Spannungszeitfläche F_{MF} und für den hochfrequenten Teil eine Spannungszeitfläche F_{HF} (Fig. 3c) gebildet. Bei Abweichungen von den Referenzwerten gibt das erfindungsgemäße Verfahren sogar Aufschluss darüber ob die Unregelmäßigkeiten vom mittelfrequenten oder hochfrequenten Teil der Anlage verursacht werden. Außer in Härteeinrichtungen kann das Verfahren auch In anderen Systemen mit induktiver Heizung, z.B. Anlagen zum Löten eingesetzt werden.

## Patentansprüche

1. Verfahren zum überwachen einer Einrichtung zum induktiven Erwärmen von Bauteilen, wobei die Einrichtung einen aus einer Induktionsspule (I) und einem Werkstück (W) bestehenden induktiven Lastzweig aufweist und wobei an der Induktionsspule (I) während der Erwärmung eine Wechselspannung (Uₛ) abfällt, **dadurch gekennzeichnet, dass** die Wechselspannung (Uₛ) erfasst wird, über die Dauer der Erwärmung eine Spannungszeitfläche (F) bestimmt und mit einer vorher festgelegten Referenzfläche verglichen wird.

2. Verfahren nach Patentanspruch 1, **dadurch gekennzeichnet, dass** die Wechselspannung abgetastet wird und dass die Abtastfrequenz mindestens doppelt so groß ist wie der höchste Frequenzanteil des Wechselspannungssignals.

3. Verfahren nach Patentanspruch 1, **dadurch gekennzeichnet, dass** die Spannungszeitfläche (F) mit Hilfe von aus der gleichgerichteten Wechselspannung fortlaufend berechneten Mittelwerten gebildet wird.

4. Verfahren nach einem der Patentansprüche 1 bis 3, wobei einer mittelfrequenten Spannung eine hochfrequente Spannung überlagert ist, **dadurch gekennzeichnet, dass** die Spannung in einen mittelfrequenten und einen hochfrequenten Teil aufgespaltet wird und dass für den mittelfrequenten Teil eine Spannungszeitfläche (F_{MF}) und für den hochfrequenten Teil eine Spannungszeitfläche (F_{HF}) ermittelt wird.

## Claims

1. Method for monitoring a device for inductively heating components, wherein the device comprises an inductive load branch consisting of an induction coil (I) and a workpiece (W), and wherein an AC voltage (Uₛ) is dropped across the induction coil (I) during heating, **characterized in that** the AC voltage (Uₛ) is detected, and a voltage-time integral (F) is determined over the duration of heating and is compared with a previously defined reference integral.

2. Method according to Patent Claim 1, **characterized in that** the AC voltage is sampled, and **in that** the sampling frequency is at least double the magnitude of the highest frequency component in the AC voltage signal.

3. Method according to Patent Claim 1, **characterized in that** the voltage-time integral (F) is formed with the aid of average values calculated continuously from the rectified AC voltage.

4. Method according to any of Patent Claims 1 to 3, wherein a high-frequency voltage is superposed on a medium-frequency voltage, **characterized in that** the voltage is split into a medium-frequency portion and a high-frequency portion, and **in that** a voltage-time integral (F_{MF}) is determined for the medium-frequency portion and a voltage-time integral (F_{HF}) is determined for the high-frequency portion.

## Revendications

1. Procédé de surveillance d'un dispositif destiné au chauffage inductif de composants, le dispositif présentant une branche de charge inductive constituée d'une bobine d'induction (I) et d'une pièce (W) et une tension alternative (Uₛ) chutant au niveau de la bobine d'induction (I) pendant le chauffage, **caractérisé en ce que** la tension alternative (Uₛ) est détectée pendant la durée du chauffage, une surface tension-temps (F) est déterminée et est comparée à une surface de référence préalablement établie.

2. Procédé selon la revendication 1, **caractérisé en ce que** la tension alternative est balayée et **en ce que** la fréquence de balayage est au moins deux fois plus grande que la composante de fréquence maximale du signal de tension alternative.

3. Procédé selon la revendication 1, **caractérisé en ce que** la surface tension-temps (F) est formée à l'aide de valeurs moyennes calculées en continu à partir de la tension alternative redressée.

4. Procédé selon l'une quelconque des revendications 1 à 3, dans lequel une tension haute fréquence est superposée à une tension moyenne fréquence, **caractérisé en ce que** la tension est séparée en une partie moyenne fréquence et une partie haute fréquence et **en ce que** pour la partie moyenne fréquence, une surface tension-temps (F_{MF}) est déterminée et pour la partie haute fréquence, une surface tension-temps (F_{HF}) est déterminée.
